(19) Europäisches Patentamt

European Patent Office

Office européen des brevets

(11) **EP 1 141 960 B1**

(12) **EUROPÄISCHE PATENTSCHRIFT**

(45) Veröffentlichungstag und Bekanntmachung des Hinweises auf die Patenterteilung:
**03.07.2002   Patentblatt 2002/27**

(21) Anmeldenummer: **00904823.2**

(22) Anmeldetag: **03.01.2000**

(51) Int Cl.7: **G11C 11/16**

(86) Internationale Anmeldenummer:
**PCT/DE00/00026**

(87) Internationale Veröffentlichungsnummer:
**WO 00/42614 (20.07.2000 Gazette 2000/29)**

(54) **SCHREIB-/LESEARCHITEKTUR FÜR MRAM**

READ/WRITE ARCHITECTURE FOR A MRAM

ARCHITECTURE D'ECRITURE/LECTURE POUR RAM MAGNETORESISTIVE

(84) Benannte Vertragsstaaten:
**DE FR GB IE IT**

(30) Priorität: **13.01.1999  DE 19900979**

(43) Veröffentlichungstag der Anmeldung:
**10.10.2001   Patentblatt 2001/41**

(73) Patentinhaber: **Infineon Technologies AG
81669 München (DE)**

(72) Erfinder:
• **RÖSNER, Wolfgang
D-85521 Ottobrunn (DE)**

• **SCHWARZL, Siegfried
D-85579 Neubiberg (DE)**

(74) Vertreter: **Müller - Hoffmann & Partner
Patentanwälte,
Innere Wiener Strasse 17
81667 München (DE)**

(56) Entgegenhaltungen:
**FR-A- 2 071 501          US-A- 3 863 231
US-A- 5 541 868**

**Beschreibung**

Die vorliegende Erfindung betrifft eine Schreib-/Lesearchitektur für einen über Wortleitungen und Bitleitungen adressierbaren MRAM (magnetoresistiver RAM bzw. Schreib-/Lesespeicher), mit

- einer Vielzahl von ferromagnetischen Speicherelementen, die an Zeilen und Spalten einer Matrix bildenden Kreuzungen der Wortleitungen mit den Bitleitungen angeordnet sind, die weiterhin jeweils aus wenigstens zwei durch eine Trennschicht getrennten ferromagnetischen Schichten bestehen und deren Widerstandswert senkrecht zur Schichtenfolge jeweils höher als derjenige der Wortleitungen bzw. der Bitleitungen ist und von dem Magnetisierungszustand der ferromagnetischen Schichten abhängt, wobei die ferromagnetischen Speicherelemente jeweils zwischen eine der wortleitungen und eine der Bitleitungen geschaltet sind.

MRAMs sind bekanntlich nichtflüchtige Schreib-/Lesespeicher, die sich im Vergleich mit anderen Arten von nichtflüchtigen und auch flüchtigen Speichern wie beispielsweise DRAMs, FRAMs (ferroelektrische RAMs), EEPROMs (elektrisch löschbare und programmierbare ROMs bzw. Festwertspeicher) und FLASHs, durch Vorteile, wie insbesondere hohe Speicherdichten bis in die Größenordnung von 100 Gbit/Chip und darüber, einfache Prozeßarchitekturen und damit niedrige Herstellungskosten je Bit auszeichnen.

Die Zellenfelder von MRAMs bestehen zweckmäßigerweise aus matrixartig angeordneten metallischen Wortleitungen und Bitleitungen, auch Schreibleitungen und Leseleitungen genannt, die in einem kartesischen xy-Koordinatensystem in x-Richtung bzw. y-Richtung verlaufend übereinander angeordnet sind und zwischen denen an den Kreuzungen der Wortleitungen mit den Bitleitungen ferromagnetische Speicherelemente vorgesehen sind. Diese ferromagnetischen Speicherelemente bestehen aus mindestens zwei übereinander liegenden ferromagnetischen Schichten, die magnetisch entkoppelt sind, was durch eine zwischen diesen ferromagnetischen Schichten vorgesehene Trennschicht geschieht. Bei dieser Trennschicht kann es sich um eine Tunnelbarriere aus beispielsweise Aluminium-oxid ($Al_2O_3$) oder auch um eine nicht-ferromagnetische leitende Schicht aus beispielsweise Kupfer handeln.

Die ferromagnetischen Schichten bestehen beispielsweise aus Eisen, Kobalt, Nickel, Permalloy (NiFe) usw., wobei Zusätze, wie beispielsweise Platin, enthalten sein können, die einen feinkristallinen Zustand begünstigen.

Die ferromagnetischen Schichten können eine Schichtdicke zwischen 3 und 20 nm haben, während die zwischen sie gelegte Trennschicht 1 bis 3 nm dick sein kann.

Die ferromagnetischen Schichten jedes Speicherelements haben unterschiedlich große Schaltfelder und können daher durch Schaltströme in den Leiterbahnen bildenden Wortleitungen und Bitleitungen unabhängig voneinander ummagnetisiert werden. Die Widerstände der einzelnen Speicherelemente haben dabei von der relativen Magnetisierung der sie bildenden ferromagnetischen Schichten abhängige Widerstandswerte: sind beide ferromagnetische Schichten parallel zueinander magnetisiert, so hat das Speicherelement einen Widerstandswert $R_0$, während bei einer antiparallelen Magnetisierung der beiden ferromagnetischen Schichten ein Widerstandswert $R_0 + \Delta R$ ($\Delta R > 0$) vorliegt. Das Verhältnis $\Delta R/R_0$ beträgt etwa 0,1 ... 0,2. Dieser Effekt wird als Magnetowiderstandseffekt bezeichnet. Für die ferromagnetischen Speicherelemente ist auch der Begriff magnetoresistive Speicherelemente gebräuchlich:

Diesen beiden Widerstandswerten der ferromagnetischen Schichten, also dem Widerstandswert $R_0$ für parallele Magnetisierung und dem Widerstandswert $R_0 + \Delta R$ für die antiparallele Magnetisierung, können nun die Größen "0" und "1" von binären Speichern zugeordnet werden.

Das Schreiben in MRAMs ist grundsätzlich einfach, wenn davon abgesehen wird, daß die hierfür notwendigen Schaltfeldstärken mit den Leiterbahnen erreicht werden müssen. Als schwieriger hat es sich erwiesen, die in den Speicherelementen als Widerstandswerte gespeicherte Information sicher und möglichst einfach, also ohne Zuhilfenahme von Auswahltransistoren, die die Speicherzellenflächen vergrößern und den Herstellungsprozeß komplexer machen, auszulesen.

Um dieses Auslesen ohne Auswahltransistoren sicher und zuverlässig zu gestalten, wurden bereits verschiedene Anstrengungen unternommen. Ein Hauptproblem beim Auslesen der in hoher Speicherdichte mit einer Zellfläche von $4 F^2$ (F = minimale Strukturgröße) angeordneten Speicherzellen liegt darin, daß jede Speicherzelle, also jedes Widerstandselement, dessen Widerstandswert ermittelt werden soll, durch eine Vielzahl paralleler Strompfade "geshunted" ist, wodurch speziell in großen Speicherzellenfeldern eine exakte Bestimmung des Widerstandswertes problematisch wird.

Zur Überwindung dieser Schwierigkeiten sind für MRAMs bisher die folgenden beiden Auslesemethoden bekannt geworden:

Bei der ersten Methode werden die Wortleitungen und die Bitleitungen voneinander elektrisch isoliert, und der Lesestrom durchfließt eine relativ kleine Anzahl, beispielsweise zehn, von in Reihe geschalteter Speicherelemente. Aus der Veränderung des Lesestromes kann dann mittels einer relativ aufwendigen Schaltung auf den Widerstandswert eines betreffenden Speicherelementes geschlossen werden (vgl. hierzu D. D. Tang, P. K. Wang, V. S. Speriosu, S. Le, R. E. Fontana, S. Rishton, IEDM 95-997).

Bei dieser Methode sind Schreibströme durch die beiden Leiterbahnen (Wortleitung und Bitleitung) notwendig, die sich an dem betreffenden Speicherelement kreuzen. Die Anzahl der in Serie geschalteten Speicherelemente wird begrenzt durch die mit zunehmender Anzahl immer kleiner werdende relative Änderung des Gesamtwiderstandes und die schwieriger werdende Messung der Stromänderung. Die geringe Anzahl der in Serie miteinander verbindbaren Speicherelemente bedingt einen großen Schaltungsaufwand für die Peripherie des Speicherfeldes und hat damit einen großen Flächenbedarf für die Leseelektronik zur Folge.

Die zweite Methode des Auslesens besteht darin, daß alle Wortleitungen und Bitleitungen mit Ausnahme der an der ausgewählten Speicherzelle liegenden Wortleitung auf Potential "0" gelegt werden. An die ausgewählte Wortleitung wird ein Potential ungleich 0 gelegt, während die ausgewählte Bitleitung und alle anderen Bitleitungen durch Verwendung eines Operationsverstärkers zur Strommessung auf ein "virtuelles" Nullpotential gebracht sind (vgl. hierzu DE 197 40 942 A1).

Beide Methoden haben den Nachteil, daß sie auf der Bestimmung des Absolutwertes des Widerstandes der einzelnen Speicherelemente beruhen, wodurch sehr hohe technologische Anforderungen an eine genaue, reproduzierbare und homogene Einstellung der Widerstandswerte über dem gesamten Speicherzellenfeld und auch über einer Halbleiterscheibe bzw. mehreren Halbleiterscheiben gestellt werden. Ebenso ist hier zu beachten, daß bei den relativ geringen Änderungen von $\Delta R/R_0$ Temperaturschwankungen Veränderungen des Widerstandswertes hervorrufen können, die eine sichere Bestimmung der Magnetisierungszustände einzelner Speicherelemente und damit deren Auslesen erschweren. Zusätzlich bewirken bei der zweiten Methode die endlichen Bitleitungswiderstände, daß die Bedingung eines virtuellen Nullpotentials nur an den Enden der Bitleitungen erfüllt ist, so daß sich bei langen Bitleitungen parasitäre Querströme negativ auswirken.

Es ist Aufgabe der vorliegenden Erfindung, eine Schreib-/Lesearchitektur für MRAMs zu schaffen, die bei einfachem Aufbau ein zuverlässiges Auslesen des Speicherzellenfeldes erlaubt und keine unrealistisch hohen Anforderungen an die exakte reproduzierbare und homogene Einstellung der Widerstandswerte der einzelnen Speicherzellen stellt.

Diese Aufgabe wird bei einer Schreib-/Lesearchitektur nach dem Oberbegriff des Patentanspruches 1 erfindungsgemäß dadurch gelöst, daß

-   mindestens ein Referenz-Speicherelement einen bekannten Magnetisierungszustand hat und

-   mittels Widerstandsbrücken das Widerstandsverhältnis jedes Speicherelements zu dem Referenz-Speicherelement bestimmbar ist.

Bei der erfindungsgemäßen Schreib-/Lesearchitektur wird so durch eine spezielle äußere Beschaltung des ein "Widerstandsraster" bildenden Speicherzellenfeldes der Magnetisierungszustand der einzelnen Speicherelemente, also die parallele bzw. antiparallele Magnetisierung der ferromagnetischen Schichten, nicht - wie bisher beim Stand der Technik üblich - durch Absolutmessung des Widerstandswertes, sondern durch Widerstandsvergleich mit Speicherelementen eines bekannten Magnetisierungszustandes ermittelt. Als Referenz-Speicherelement muß dabei wenigstens ein Speicherelement vorgesehen werden, wobei zweckmäßigerweise auch eine ganze Spalte und/oder eine ganze Zeile der Speicherelemente einen bekannten Magnetisierungszustand aufweisen kann. Ein solcher bekannter Magnetisierungszustand ist dabei beispielsweise eine parallele Magnetisierung beider ferromagnetischen Schichten mit dem niedrigen Widerstandswert $R_0$ oder eine antiparallele Magnetisierung der beiden Widerstandsschichten mit dem Widerstandswert $R_0 + \Delta R$ ($\Delta R > 0$). Dieser bekannte Magnetisierungszustand ist vor dem eigentlichen Leseprozeß einzuschreiben.

Der Vergleich der Widerstände erfolgt durch Widerstandsbrükken, nämlich Halbbrücken oder Vollbrücken, die durch die erwähnte äußere Beschaltung des Widerstandsrasters entstehen.

An den Mittelabgriffen dieser Widerstandsbrücken entstehen Spannungen, die auf die relative Größe der Widerstände in den Widerstandsbrücken und damit auf die in den einzelnen Speicherelementen gespeicherten Informationen, also "0" (beispielsweise parallele Magnetisierung) oder "1" (beispielsweise antiparallele Magnetisierung) schließen lassen.

Bei verschwindender Querspannung an den Widerstandsbrücken stimmen die Widerstände überein und haben beispielsweise beide den Wert $R_0$. Ist die Querspannung jedoch von Null verschieden, so hat der gesuchte Widerstand einen vom Widerstand des Referenz-Speicherelementes abweichenden Wert, nämlich beispielsweise $R_0 + \Delta R$.

Beim Lesen können beispielsweise an das Referenz-Speicherelement eine Spannung -V/2 angelegt werden, während an ein zu lesendes Speicherelement dann die Spannung +V/2 anlegbar ist.

Die Materialien für die einzelnen Speicherelemente sind die gleichen, wie diese bereits oben erwähnt wurden: die Trennschicht zwischen den ferromagnetischen Schichten kann aus beispielsweise $Al_2O_3$ oder aus Kupfer bestehen und eine Schichtdicke zwischen 1 und 3 nm aufweisen, während die ferromagnetischen Schichten selbst in üblicher

EP 1 141 960 B1

Weise aus Eisen, Kobalt, Nickel, Permalloy mit entsprechenden Zusätzen (beispielsweise Platin) aufgebaut sind und eine Schichtdicke zwischen 3 und 20 nm haben.

In einer vorteilhaften Weiterbildung der Erfindung ist vorgesehen, daß zum Widerstandsvergleich in den einzelnen Widerstandsbrücken Stromfolger bzw. Verstärker eingesetzt werden, deren Ausgangsspannung von der Anzahl m der Wortleitungen im Widerstandsraster unabhängig sind. Dadurch ist es möglich, große Zellenfelder zu verwenden, so daß auch das Flächenverhältnis des Speicherzellenfeldes zur Ausleseelektronik zunimmt.

Ein wesentlicher Vorteil der Erfindung liegt darin, daß sie ein großes Speicherzellenfeld mit Speicherzellen ohne Auswahltransistoren ermöglicht, wobei sogar das beim Auslesen einer Speicherzelle gewonnene Meßsignal von der Größe des Speicherzellenfeldes mit Hilfe der erwähnten Stromfolger unabhängig gemacht werden kann.

Zusätzliche Vorteile, die mit der Erfindung zu erzielen sind, können wie folgt zusammengefaßt werden:

- Die Ausleseelektronik ist vergleichsweise einfach aufgebaut und hat lediglich die Aufgabe, zwischen Symmetrie oder Unsymmetrie der einzelnen Widerstandsbrücken zu unterscheiden.

- Das Meßsignal ist im Gegensatz zum Stand der Technik vollkommen vom Absolutwert der einzelnen Widerstandselemente unabhängig; es hängt lediglich von den an das Speicherzellenfeld angelegten Spannungen und dem Magnetowiderstandseffekt $\Delta R/R_0$ der einzelnen Speicherelemente ab.

- Die technologischen Anforderungen an Genauigkeit, Reproduzierbarkeit und Homogenität bei der Herstellung des Speicherzellenfeldes sind reduziert, da das Lesen allein auf dem Vergleich nahe zueinander benachbarter Widerstände innerhalb des Speicherzellenfeldes beruht. Im Gegensatz zu der beim Stand der Technik üblichen Absolutwertbestimmung der Widerstände wird bei der erfindungsgemäßen Schreib-/Lesearchitektur das Meßsignal in voller Größe zur Unterscheidung der beiden Widerstandszustände herangezogen und ist nicht nur in einer kleinen Änderung der Meßgröße enthalten.

- Temperaturbedingte Widerstandsänderungen haben auf das Lesesignal keinen Einfluß, da sie sich in der Brückenschaltung aufheben.

- Es ist das Auslesen von relativ großen Speicherzellenfeldern ohne Auswahltransistoren möglich, was erhebliche Vorteile hinsichtlich Speicherdichte, Prozeßeinfachheit und Kosten pro Bit bedeutet.

- Leitungswiderstände der Wortleitungen und der Bitleitungen sind aus Symmetriegründen wenigstens teilweise unwirksam.

Nachfolgend wird die Erfindung anhand der Zeichnungen, in denen Ausführungsbeispiele dargestellt sind, näher erläutert.
Es zeigen:

Fig. 1          ein Speicherzellenfeld eines MRAMs ohne Auswahltransistoren in Perspektive,

Fig. 2          ein Speicherzellenfeld entsprechend Fig. 1 in einer perspektivisch dargestellten Schaltung,

Fig. 3          das Speicherzellenfeld von Fig. 2 bei einem Auslesevorgang,

Fig. 4          eine elektrische Schaltung von Halbbrücken, wenn an Wortleitungen Spannungen -V/2 bzw. +V/2 liegen,

Fig. 5          eine Schaltung von Halbbrücken, wenn an Bitleitungen Spannungen von -V/2 bzw. +V/2 liegen,

Fig. 6 bis 8     Brückenschaltungen zur Erläuterung der jeweils an den Brücken abgegriffenen Spannungen,

Fig. 9          eine Brückenschaltung, anhand der erläutert ist, wie abhängig von den Widerstandswerten unterschiedliche logische Zustände zu gewinnen sind,

Fig. 10         eine Brückenschaltung mit Stromfolgern gemäß einem besonders vorteilhaften Ausführungsbeispiel der Erfindung und

Fig. 11 und 12   einen Vergleich zwischen einer Brückenschaltung ohne Stromfolger (Fig. 11) und einer Brückenschalter mit Stromfolger (Fig. 12).

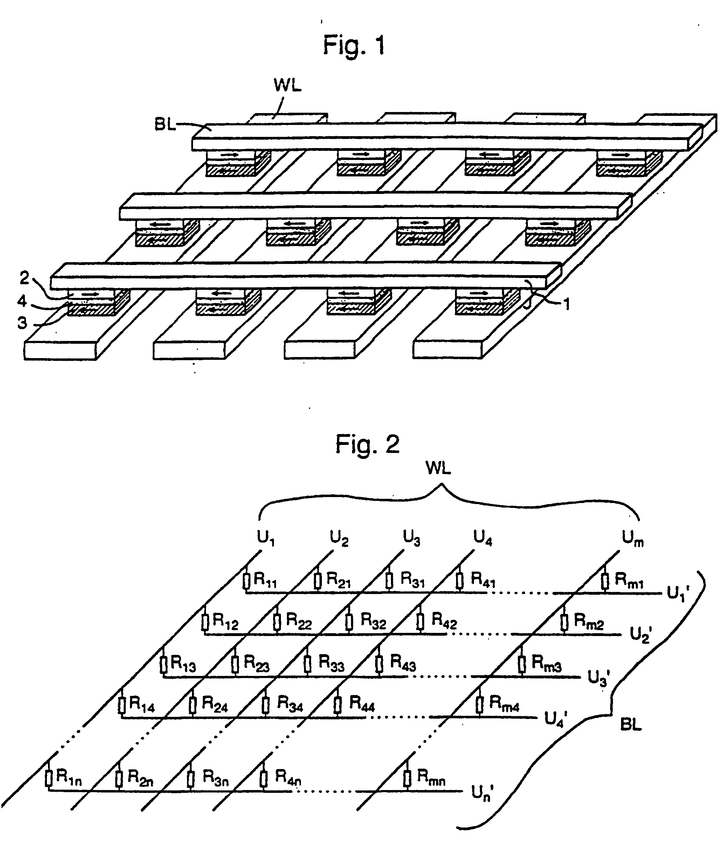

Fig. 1 zeigt ein Speicherzellenfeld eines MRAMs ohne Auswahltransistoren mit sogenannten "4 F$^2$"-Speicherzellen aus ferromagnetischen Speicherelementen 1, Wortleitungen WL und Bitleitungen BL. Die Speicherzellen 1 liegen dabei an den Kreuzungen zwischen den Wortleitungen WL und Bitleitungen BL und bestehen jeweils aus ferromagnetischen Schichten 2, 3, zwischen denen eine Trennschicht 4 vorgesehen ist. Diese Trennschicht 4 kann eine Tunnelbarriere aus beispielsweise Aluminiumoxid oder eine nicht-ferromagnetische leitende Schicht aus beispielsweise Kupfer sein.

Die Wortleitungen WL und die Bitleitungen BL verlaufen in y-bzw. x-Richtung, so daß die Speicherzellen 1 ein matrixähnliches Widerstandsraster bilden.

Der Widerstandswert der einzelnen Speicherzellen 1 hängt von den Magnetisierungsrichtungen der beiden ferromagnetischen Schichten 2, 3 ab. Bei paralleler Magnetisierung der ferromagnetischen Schichten 2, 3 zueinander ist der Widerstand klein und hat einen Wert $R_0$, während bei antiparalleler Magnetisierung der Widerstandsschichten 2, 3 der Widerstandswert eine Größe $R_0 + \Delta R$, $\Delta R > 0$, aufweist.

Die Leiterbahnen bildenden Wortleitungen WL und Bitleitungen BL können beispielsweise aus Aluminium bestehen. Bevorzugte Schichtdicken für die ferromagnetischen Schichten 2, 3 sind beispielsweise 3 bis 20 mm und für die Trennschichten 4 sind beispielsweise 1 bis 3 mm.

Durch Anlegen entsprechender elektrischer Spannungen an eine bestimmte Wortleitung WL und eine bestimmte Bitleitung BL können die ferromagnetischen Schichten des an der Kreuzungsstelle dieser Wortleitung WL und dieser Bitleitung BL liegenden Speicherelementes parallel oder antiparallel magnetisiert werden.

Eine parallele Magnetisierung mit niedrigem Widerstandswert kann dann beispielsweise einer logischen "0" zugeordnet werden, während eine antiparallele Magnetisierung mit hohem Widerstandswert einer logischen "1" entspricht.

Fig. 2 zeigt ein elektrisches Schaltbild eines zu Fig. 1 ähnlichen Speicherzellenfeldes, wobei hier an m Wortleitungen WL Spannungen $U_1$, $U_2$, ..., $U_m$ und an n Bitleitungen BL Spannungen $U_1'$, $U_2'$, ..., $U_n'$ anliegen. Die einzelnen Speicherzellen sind durch Widerstände $R_{11}$, $R_{21}$, ..., $R_{12}$, $R_{22}$, ... $R_{ik}$, ..., $R_{mn}$ veranschaulicht. Aus der Fig. 2 ist zu ersehen, wie die einzelnen Speicherzellen ein Widerstandsraster bilden, wobei die Widerstandswerte der einzelnen Widerstände $R_{ik}$ von deren Magnetisierungszustand (parallele Magnetisierung mit niedrigem Widerstandswert bzw. antiparallele Magnetisierung mit hohem Widerstandswert) abhängt.

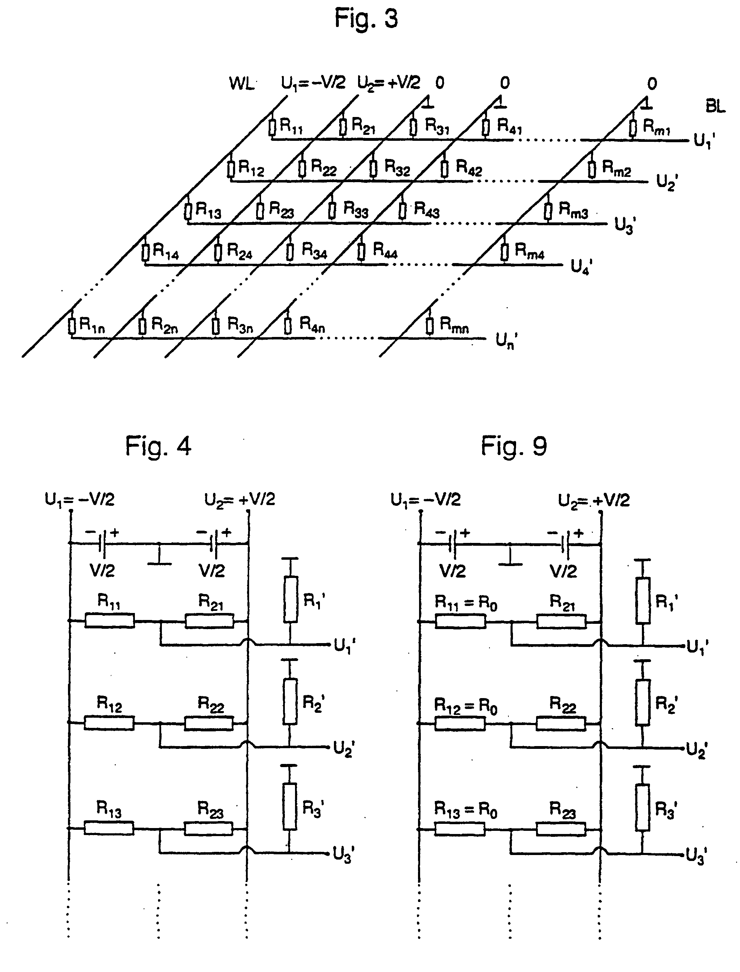

An zwei beliebige Wortleitungen WL wird nun eine Spannung von - V/2 bzw. von +V/2 angelegt, so daß $U_i$ = -V/2 und $U_k$ = +V/2 gelten. An den übrigen Wortleitungen WL liegt ein Potential "0". Diese Situation ist in Fig. 3 für den Fall i = 1 und k = 2 dargestellt.

Durch den Parallelschluß, der auf Potential "0" liegenden Widerstände $R_{31}$, $R_{41}$, ..., $R_{32}$, $R_{42}$, ..., $R_{3k}$, $R_{4n}$, ···, $R_{mn}$ jeder Bitleitung BL entstehen Halbbrücken, wie dies schematisch in Fig. 4 veranschaulicht ist, wobei hier der Widerstand $R_1'$ den Widerstand der parallel zueinander liegenden Widerstände $R_{31}$, $R_{41}$, ..., $R_{m1}$ bedeutet. Entsprechendes gilt für die Widerstände $R_2'$ bzw. $R_3'$.

Die Spannungen $U_1'$, $U_2'$, $U_3'$, ..., $U_i'$ (i = 1, 2, ..., n) hängen nun vom Verhältnis der beiden Widerstände in jeder Halbbrücke ab: liegt beispielsweise $R_{11}$ = $R_{21}$ vor, so gilt $U_1'$ = 0. Gilt $U_1'$ < 0, so liegt $R_{1:}$ < $R_{21}$ vor. $U_1'$ > 0 ist dagegen $R_{11}$ > $R_{21}$ zugeordnet.

Für die Querwiderstände $R_{i'}$, an denen die Spannungen $U_1'$, ... $U_i'$ abfallen, gilt:

$$R_0/(m-2) \leq R_i' \leq (R_0 + \Delta R)/(m-2) \tag{1}$$

Die untere Grenze $R_0/(m-2)$ liegt dabei vor, wenn alle Widerstände $R_{3i}$, $R_{4i}$, ..., $R_{mi}$ eine parallele Magnetisierung der ferromagnetischen Schichten zeigen, während die obere Grenze $(R_0 + \Delta R)/(m-2)$ zutrifft, wenn diese Widerstände alle antiparallel magnetisiert sind.

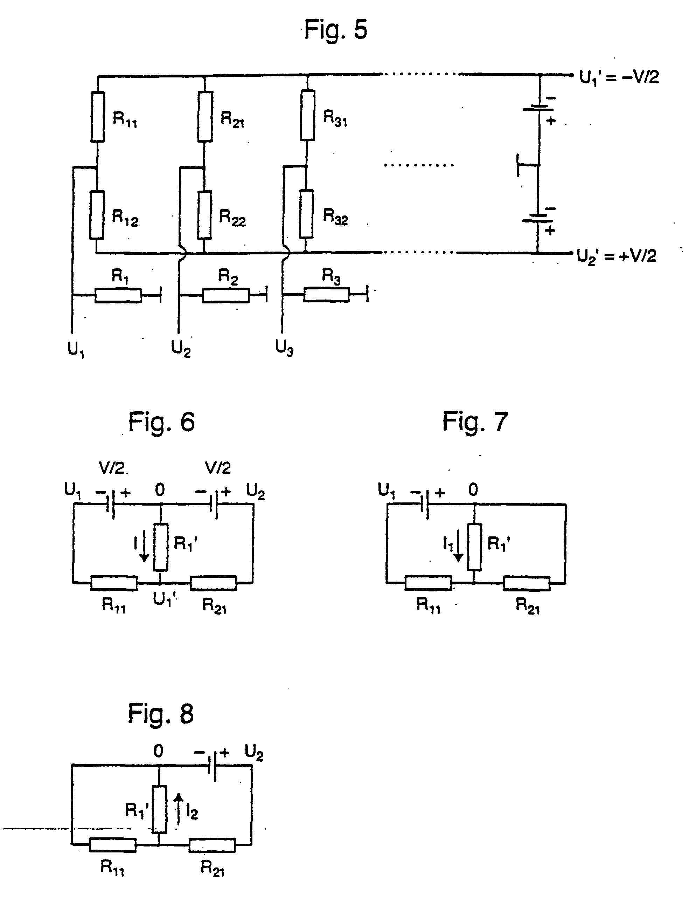

Anstelle der Beaufschlagung von zwei Wortleitungen WL mit den Spannungen -V/2 bzw. +V/2 können auch zwei Bitleitungen BL an diese Spannungen gelegt werden. Dieser Fall ist in Fig. 5 schematisch veranschaulicht, wobei dann hier die Spannungen $U_1$, $U_2$, ..., $U_i$ (i = 1, 2, ..., m) Auskunft über die Widerstandsverhältnisse $R_{ik}/R_{ik+1}$ (i = 1, 2, ..., m, k-1 ... n) geben.

Es können auf diese Weise beliebige Zeilen bzw. Spalten miteinander verglichen werden.

Beim Schreiben in einen solchen MRAM werden gleichzeitig Ströme geeigneter Größe durch je eine Wortleitung WL und eine Bitleitung BL geschickt. Dadurch kann das an der Kreuzung dieser Wortleitung mit dieser Bitleitung liegende Speicherelement in einen parallel oder antiparallel magnetisierten Zustand seiner ferromagnetischen Schichten 2, 3 überführt werden, der einer logischen "0" bzw. "1" entspricht.

Voraussetzung für ein anschließendes Auslesen ist nun, daß beispielsweise alle Speicherelemente einer Wortleitung, wie der ersten Wortleitung mit der Spannung $U_1$, in einen bekannten Magnetisierungszustand überführt werden, also beispielsweise in eine parallele Magnetisierung der ferromagnetischen Schichten 2, 3, wobei aber der entsprechende Widerstandswert $R_0$ nicht bekannt zu sein braucht.

Beim Lesen werden an zwei Wortleitungen, beispielsweise die erste und die zweite Wortleitung mit den Spannungen $U_1$ bzw. $U_2$ in Fig. 2 bis 4 die Potentiale -V/2 bzw. +V/2 gelegt. Der Mittelkontakt der Spannungsquelle liegt auf Potential 0 ebenso wie die übrigen niederohmig miteinander verbundenen Wortleitungen WL 3 bis WL m. Die Querwiderstände $R_i'$ der dadurch entstehenden Halbbrücken werden durch Parallelschaltung der an jeder Bitleitung BL angeschlossenen Widerstände $R_{3i}$ bis $R_{mi}$ (i = 1, 2, ... n) gebildet. An diesen Widerständen $R_i'$ die in dem oben durch Ausdruck (1) gegebenen Intervall liegen, fallen die Spannungen $U_i'$ (i = 1, 2, ..., n) ab, die einen Vergleich der Widerstände $R_{2i}$ mit den Widerständen $R_{1i}$ erlauben, wie dies schematisch anhand der Fig. 6 bis 8 gezeigt werden kann.

Die Fig. 6 bis 8 zeigen die Brückenspannungen $U_i'$ (i = 1, ..., n) für das Beispiel der obersten Halbbrücke in Fig. 4. Der Strom I durch den Widerstand $R_1'$ (vgl. Fig. 6) entsteht durch Überlagerung der Ströme $I_1$ (vgl. Fig. 7) und $I_2$ (vgl. Fig. 8), die von den beiden Spannungsquellen $U_1$ und $U_2$ unabhängig voneinander erzeugt werden, wobei jeweils die andere Spannungsquelle durch eine Kurzschlußbrücke ersetzt wird (vgl. Fig. 7 und 8). Dieser Strom I erzeugt über dem Widerstand $R_1'$ eine Spannung $U_1'$, die vergleichende Aussagen über die Widerstandswerte der Widerstände $R_{11}$ und $R_{21}$ zuläßt.

Im einzelnen sind die Ströme $I_1$, $I_2$ und I gegeben durch:

$$I_1 = \frac{U_1}{R_{11} + \frac{R_1'R_{21}}{R_1'+R_{21}}} \frac{R_{21}}{R'_1+R_{21}} = \frac{U_1 R_{21}}{R_{11}R_1'+R_{11}R_{21} + R_1'R_{21}} \tag{2}$$

$$I_2 = \frac{U_2 R_{11}}{R_{11}R'_1+R_{11}R_{21} + R_1'R_{21}} \tag{3}$$

$$I = I_1 + I_2 = \frac{U_1 R_{21} + U_2 R_{11}}{R_{11}R_1'+R_{11}R_{21} + R_1'R_{21}} \tag{4}$$

Daraus folgt dann für die Spannung $U_1'$ :

$$U_1' = I\,R_1' = \frac{V}{2} \frac{R_1'(R_{11} - R_{21})}{R_{11}R_1'+R_{11}R_{21} + R_1'R_{21}} \tag{5}$$

Für die Spannung $U_1'$ werden abhängig von den Widerständen $R_{11}$ und $R_{21}$ bzw. den Magnetisierungswiderständen der ferromagnetischen Schichten 2, 3 die folgenden Werte erhalten:

$$U_1' = \begin{cases} 0 & \text{für } R_{11} = R_{21} \\ > 0 & \text{für } R_{11} > R_{21} \\ < 0 & \text{für } R_{11} < R_{21} \end{cases} \tag{6}$$

Allgemein gelten für den Vergleich der Matrixwiderstände $R_{ji}$ mit den Widerständen $R_{1i}$ an der ersten Wortleitung WL 1 die folgenden Beziehungen:

$$U_i' = \begin{cases} 0 \ \text{für } R_{1i} = R_{ji} \\ > 0 \ \text{für } R_{1i} > R_{ji} \\ < 0 \ \text{für } R_{1i} < R_{ji} \end{cases} \quad (i = 1...n; j = 2...m) \tag{7}$$

Nach Feststellung der Widerstandswerte für die beiden ersten Wortleitungen, beispielsweise mittels Komparatoren an den Bitleitungen BL, kann der Vorgang nacheinander mit weiteren Wortleitungspaaren, also beispielsweise den Wortleitungen WL 1 und WL 3, WL 1 und WL 4, ..., WL 1 und WL m wiederholt werden, bis die Magnetisierungszustände aller Widerstände in der Matrix ermittelt sind.

Dabei gilt allgemein für die Spannungen $U_i'$:

$$U_i' = I\,R_i' = \frac{V}{2}\,\frac{R_i'(R_{1i} - R_{ji})}{R_{1i}R_{i'} + R_{1i}R_{ji} + R_i'R_{ji}} \ (i = 1...n; j = 3...m) \tag{8}$$

Mit der bereits erwähnten Beziehung (1) folgt daraus:

$$\frac{V}{2}\,\frac{\Delta R/R}{\Delta R/R(m-1) + m} \le U_i' \le \frac{V}{2}\,\frac{\Delta R/R}{\Delta R/R + m} \tag{9}$$

Als Beispiel ergibt sich für ein Speicherzellenfeld mit 1000 Bitleitungen BL (n = 1000) und 100 Wortleitungen WL (m = 100), einem Magnetowiderstandseffekt $\Delta R/R_0 = 0{,}2$ und Spannungsquellen von je 1 V:

$U_i' = 0$ für gleiche Widerstände in der i-ten Halbbrücke, $U_i' < 0$ mit $1{,}67\ \text{mV} \le |U_i'| \le 2{,}00\ \text{mV}$ für ungleiche Widerstände in der i-ten Halbbrücke unabhängig vom Widerstandswert $R_0$.

Die Belastung der Stromquellen beträgt in diesem Fall 1000 x 10 µA = 10 mA für $R_0$ = 100 kOhm und 1000 x 1 mA = 1 mA für $R_0$ = 1 MOhm.

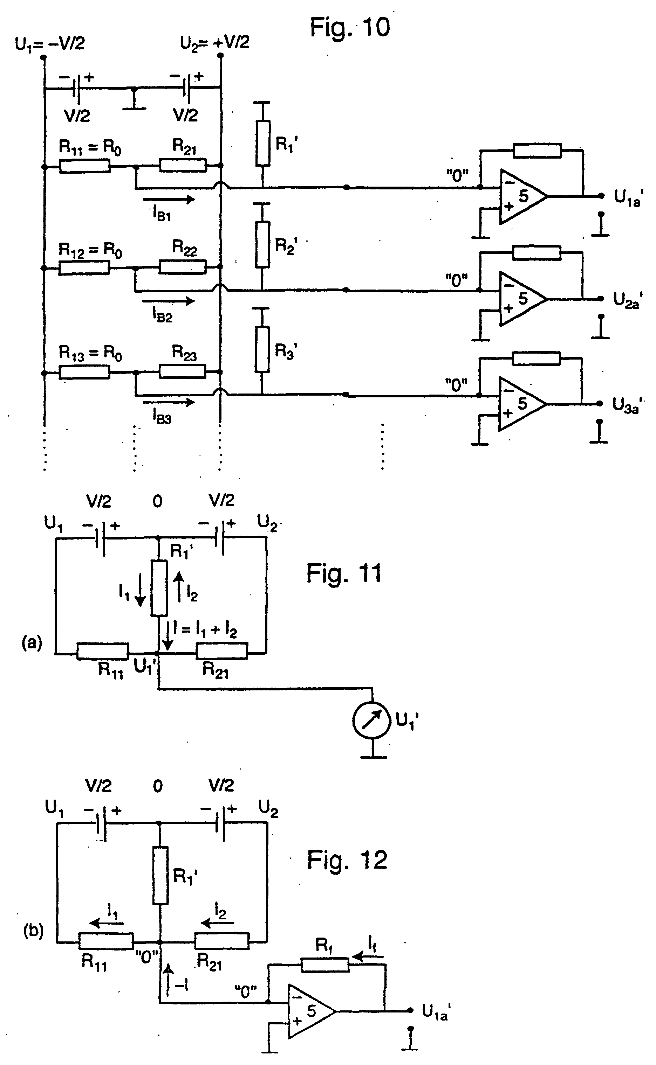

Fig. 9 zeigt einen Fall, in welchem für alle Speicherelemente der ersten Wortleitung WL 1 der parallele Magnetisierungszustand der ferromagnetischen Schichten 2, 3 mit dem niedrigen Widerstandswert $R_0$ eingeschrieben wurde. Aus verschwindenden Werten der Brückenspannungen $U_i' = 0$ folgt dann, daß auch die anderen Widerstände der Halbbrücken den Wert $R_0$ aufweisen. Ist deren Wert jedoch negativ, so haben diese Widerstände den höheren Wert $R_0 + \Delta R$. Es liegt also folgender Zusammenhang vor:

$$\begin{aligned}
U_1' = 0 &\Longrightarrow R_{21} = R_0 \\
< 0 &\Longrightarrow R_{21} = R_0 + \Delta R \\[1em]
U_2' = 0 &\Longrightarrow R_{22} = R_0 \\
< 0 &\Longrightarrow R_{22} = R_0 + \Delta R \\[1em]
U_3' = 0 &\Longrightarrow R_{23} = R_0 \\
< 0 &\Longrightarrow R_{23} = R_0 + \Delta R \\[1em]
U_j' = 0 &\Longrightarrow R_{2i} = R_0 \\
< 0 &\Longrightarrow R_{2i} = R_0 + \Delta R
\end{aligned} \qquad (i = 1 \ ... \ n) \tag{10}$$

Bei den obigen Ausführungsbeispielen werden zur Unterscheidung des kleinen Widerstandswertes (parallele Magnetisierung) und des großen Widerstandswertes (antiparallele Magnetisierung) die Querspannungen herangezogen. Dabei werden bei Speicherzellenfeldern mit einer großen Anzahl m von Wortleitungen bzw. n von Bitleitungen die Signale näherungsweise proportional zu m (bzw. n) klein. Um diesen Nachteil zu vermeiden, werden zum Widerstandsvergleich in die einzelnen Widerstandsbrücken Stromfolger eingesetzt, deren Ausgangsspannungen dann von der Anzahl m der Wortleitungen (bzw. der Anzahl n der Bitleitungen) im Widerstandsraster unabhängig sind.

Dies bringt den zusätzlichen Vorteil mit sich, daß große Speicherzellenfelder verwendet werden können, wodurch das Flächenverhältnis von Speicherzellenfeld zu Ausleseelektronik zunimmt.

Fig. 10 zeigt ein Ausführungsbeispiel, bei dem Stromfolger 5 an den Ausgängen der einzelnen Widerstandsbrücken vorgesehen sind.

Durch solche Stromfolger kann der Nachteil vermieden werden, daß die Spannung $U_i'$ gegen Null geht, wenn die Anzahl der Wortleitungen m immer größer wird. Dieser Zusammenhang soll im folgenden zunächst anhand der Fig. 11 erläutert werden:

Entsprechend Gleichung (5) gilt zunächst:

$$U_1' = IR_1' = \frac{V}{2} \frac{R_1' (R_{11} - R_{21})}{R_{11}R_1' + R_{11}R_{21} + R_1'R_{21}} \tag{11}$$

Mit $R_{11} = R_0$ und $R_{21} = R_0 + \Delta R$ folgt daraus:

$$|U_1'| = \frac{V}{2} \frac{\Delta R}{2R_0 + \Delta R + (R_0 + R_{21}\Delta R)R_0 / R_1'} \tag{12}$$

Mit $R_0/(m-2) \leq |R_1'| \leq (R_0 + \Delta R)/(m-2)$ ergibt sich sodann:

$$\frac{V}{2} \frac{\Delta R / R_0}{\Delta R/R_0(m-1) + m} \leq |U_1'| \leq \frac{V}{2} \frac{\Delta R/R_0}{\Delta R/R_0 + m} \tag{13}$$

Daraus folgt sodann:

$$|U_1'| \rightarrow 0 \text{ für } m \rightarrow \infty \tag{14}$$

Als Beispiel ergibt sich mit m = 100 Wortleitungen, $\Delta R/R_0 = 0{,}2$ und U = 2 V:

$U_i' = 0$ für gleiche Widerstände in der i-ten Halbbrücke und
$U_i' < 0$ für verschiedene Widerstände in der i-ten Halbbrücke mit 1,67 mV $< |U_1'| <$ 2,0 mV.

Fig. 12 zeigt demgegenüber den Vorteil, der mit dem Einsatz eines Stromfolgers 5 zu erzielen ist:
Zunächst gilt für die Ströme:

$$- I = I_1 - I_2 = \frac{V}{2R_{11}} - \frac{V}{2R_{21}} \tag{15}$$

Mit $R_{11} = R_0$, $R_{21} = R_0 + \Delta R$ ergibt sich:

$$- I = \frac{V}{2R_0} - \frac{V}{2(R_0 + \Delta R)} = \frac{V}{2} \frac{\Delta R}{(R_0 + \Delta R)} \tag{16}$$

Mit $U_{ia}' = -R_f I$ folgt:

$$U_{1a}' = R_f \frac{V}{2} \frac{\Delta R}{(R_0 + \Delta R)} = \frac{R_f}{R_0} \frac{V}{2} \frac{\Delta R / R0}{(1 + \Delta R / R_0)} \tag{17}$$

Aus Gleichung (17) ist zu ersehen, daß die Ausgangsspannung $U_{1a}'$ unabhängig von m und damit unabhängig von der Anzahl der Wortleitungen ist.

Ein konkretes Beispiel mit $\Delta R/R_0 = 0,2$, $U = 2$ V und $R_f = R_0$ ($R_f$ ist der Widerstandswert des Stromfolgers 5) ergibt:

$U_{1a}' = 0$ für gleiche Widerstände in der i-ten Halbbrücke und

$U_{1a}' = 0,2/1,2$ V $= 0,166$ V für verschiedene Widerstände in der i-ten Halbbrücke, unabhängig von m.

**Patentansprüche**

1. Schreib-/Lesearchitektur für einen über Wortleitungen (WL) und Bitleitungen (BL) adressierbaren MRAM, mit

   - einer Vielzahl von ferromagnetischen Speicherelementen (1), die an Zeilen und Spalten einer Matrix bildenden Kreuzungen der Wortleitungen mit den Bitleitungen angeordnet sind, die weiterhin jeweils aus zwei durch eine Trennschicht (4) getrennten ferromagnetischen Schichten (2, 3) bestehen und deren Widerstandswert senkrecht zur Schichtenfolge jeweils höher als derjenige der Wortleitungen (WL) bzw. der Bitleitung (BL) ist und von dem Mangnetisierungszustand der ferromagnetischen Schichten (2, 3) abhängt, wobei die ferromagnetischen Speicherelemente (1) jeweils zwischen eine der Wortleitungen und eine der Bitleitungen geschaltet sind,

   **dadurch gekennzeichnet, dass**

   - mindestens ein Referenz-Speicherelement einen bekannten Magnetisierungszustand hat, und
   - mittels Widerstandsbrücken das Widerstandsverhältnis jedes Speicherelements (1) zu dem Referenz-Speicherelement bestimmbar ist.

2. Schreib-/Lesearchitektur nach Anspruch 1,
   **dadurch gekennzeichnet,**
   **daß** die Speicherelemente (1) einer Zeile und/oder einer Spalte Referenz-Speicherelemente sind.

3. Schreib-/Lesearchitektur nach Anspruch 1,
   **dadurch gekennzeichnet,**
   **daß** die Widerstandsbrücken Halbbrücken oder Vollbrücken sind.

4. Schreib-/Lesearchitektur nach einem der Ansprüche 1 bis 3,
   **dadurch gekennzeichnet,**
   **daß** an das Referenz-Speicherelement und an ein weiteres Speicherelement die Spannungen -V/2 bzw. +V/2 anlegbar sind.

5. Schreib-/Lesearchitektur nach einem der Ansprüche 1 bis 4,
   **dadurch gekennzeichnet,**
   **daß** die Trennschicht eine Barriereschicht oder eine leitende Schicht aus nicht-ferroelektrischem Material ist.

6. Schreib-/Lesearchitektur nach Anspruch 5,
   **dadurch gekennzeichnet,**
   **daß** die Barriereschicht aus $Al_2O_3$ besteht.

7. Schreib-/Lesearchitektur nach Anspruch 5,
   **dadurch gekennzeichnet,**
   **daß** die Trennschicht aus Kupfer besteht.

8. Schreib-/Lesearchitektur nach einem der Ansprüche 1 bis 7,
   **dadurch gekennzeichnet,**
   **daß** die Trennschicht eine Schichtdicke von 1 bis 3 nm aufweist.

9. Schreib-/Lesearchitektur nach einem der Ansprüche 1 bis 8,

**dadurch gekennzeichnet,**
**daß** die ferromagnetischen Schichten (2, 3) eine Schichtdicke von 3 bis 20 mm aufweisen.

10. Schreib-/Lesearchitektur nach einem der Ansprüche 1 bis 9,
    **dadurch gekennzeichnet,**
    **daß** die Widerstandsbrücken mit Stromfolgern (5) versehen sind.

11. Schreib-/Lesearchitektur nach Anspruch 10,
    **dadurch gekennzeichnet,**
    **daß** je Zeile bzw. je Spalte ein Stromfolger vorgesehen ist.

**Claims**

1. Read/write architecture for an MRAM addressable via word lines (WL) and bit lines (BL), having

   - a multiplicity of ferromagnetic memory elements (1) which are arranged at crossovers between the word lines and the bit lines, said crossovers forming rows and columns of a matrix, which furthermore each comprise two ferromagnetic layers (2, 3) separated by a separating layer (4), and whose resistance perpendicular to the layer sequence is in each case higher than that of the word lines (WL) and of the bit line (BL) and depends on the magnetization state of the ferromagnetic layers (2, 3), the ferromagnetic memory elements (1) each being connected between one of the word lines and one of the bit lines,

   **characterized in that**

   - at least one reference memory element has a known magnetization state, and
   - the resistance ratio of each memory element (1) to the reference memory element can be determined by means of resistance bridges.

2. Read/write architecture according to Claim 1,
   **characterized**
   **in that** the memory elements (1) of a row and/or of a column are reference memory elements.

3. Read/write architecture according to Claim 1,
   **characterized**
   **in that** the resistance bridges are half-bridges or full bridges.

4. Read/write architecture according to one of Claims 1 to 3,
   **characterized**
   **in that** the voltages -V/2 and +V/2 can be respectively applied to the reference memory element and to a further memory element.

5. Read/write architecture according to one of Claims 1 to 4,
   **characterized**
   **in that** the separating layer is a barrier layer or a conductive layer made of non-ferroelectric material.

6. Read/write architecture according to Claim 5,
   **characterized**
   **in that** the barrier layer is composed of $Al_2O_3$.

7. Read/write architecture according to Claim 5,
   **characterized**
   **in that** the separating layer is composed of copper.

8. Read/write architecture according to one of Claims 1 to 7,
   **characterized**
   **in that** the separating layer has a layer thickness of 1 to 3 nm.

**9.** Read/write architecture according to one of Claims 1 to 8,
**characterized**
**in that** the ferromagnetic layers (2, 3) have a layer thickness of 3 to 20 mm [sic].

**10.** Read/write architecture according to one of Claims 1 to 9,
**characterized**
**in that** the resistance bridges are provided with current followers (5).

**11.** Read/write architecture according to Claim 10,
**characterized**
**in that** one current follower is provided per row and per column, respectively.

**Revendications**

**1.** Architecture de lecture-écriture pour une MRAM adressable par l'intermédiaire de conducteurs de mots (WL) et de conducteurs de bits (BL), avec

- une multiplicité d'éléments de mémoire ferromagnétiques (1) qui sont disposés aux intersections des conducteurs de mots et des conducteurs de bits formant une matrice de lignes et de colonnes, qui sont constitués chacun d'au moins deux couches ferromagnétiques (2, 3) séparées par une couche de séparation (4) et dont la valeur résistive perpendiculairement à la succession de couches est respectivement supérieure à celle des conducteurs de mots (WL) ou des conducteurs de bits (BL) et dépend de l'état de magnétisation des couches ferromagnétiques (2, 3), les éléments de mémoire ferromagnétiques (1) étant branchés chacun entre l'un des conducteurs de mots et l'un des conducteurs de bits,

　**caractérisée par le fait que**

- au moins un élément de mémoire de référence a un état de magnétisation connu, et
- le rapport de résistances de chaque élément de mémoire (1) à l'élément de mémoire de référence peut être déterminé au moyen de ponts de résistances.

**2.** Architecture de lecture-écriture selon la revendication 1,
**caractérisée par le fait que** les éléments de mémoire (1) d'une ligne et/ou d'une colonne sont des éléments de mémoire de référence.

**3.** Architecture de lecture-écriture selon la revendication 1,
**caractérisée par le fait que** les ponts de résistances sont des demi-ponts ou des ponts intégraux.

**4.** Architecture de lecture-écriture selon l'une des revendications 1 à 3,
**caractérisée par le fait que** les tensions - V / 2 respectivement + V / 2 peuvent être appliquées à l'élément de mémoire de référence et à un autre élément de mémoire.

**5.** Architecture de lecture-écriture selon l'une des revendications 1 à 4,
**caractérisée par le fait que** la couche de séparation est une couche de barrière ou une couche conductrice en un matériau non ferroélectrique.

**6.** Architecture de lecture-écriture selon la revendication 5,
**caractérisée par le fait que** la couche de barrière est en $Al_2O_3$.

**7.** Architecture de lecture-écriture selon la revendication 5,
**caractérisée par le fait que** la couche de séparation est en cuivre.

**8.** Architecture de lecture-écriture selon l'une des revendications 1 à 7,
**caractérisée par le fait que** la couche de séparation a une épaisseur de couche comprise entre 1 et 3 nm.

**9.** Architecture de lecture-écriture selon l'une des revendications 1 à 8,
**caractérisée par le fait que** les couches ferromagnétiques (2, 3) ont une épaisseur de couche comprise entre 3 et 20 nm.

10. Architecture de lecture-écriture selon l'une des revendications 1 à 9,
    **caractérisée par le fait que** les ponts de résistances sont munis de suiveurs de courant (5).

11. Architecture de lecture-écriture selon la revendication 10,
    **caractérisée par le fait qu'**il est prévu un suiveur de courant par ligne respectivement par colonne.

## Fig. 1

## Fig. 2

## Fig. 3

## Fig. 4

## Fig. 9

## Fig. 5

## Fig. 6

## Fig. 7

## Fig. 8

Fig. 10

Fig. 11

Fig. 12